(19) Europäisches Patentamt
European Patent Office
Office européen des brevets

(11) **EP 3 448 132 A1**

(12) **EUROPEAN PATENT APPLICATION**

(43) Date of publication:
**27.02.2019 Bulletin 2019/09**

(51) Int Cl.:
**H05K 1/02** *(2006.01)*

(21) Application number: **17187355.7**

(22) Date of filing: **22.08.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Vestel Elektronik Sanayi ve Ticaret A.S.
45030 Manisa (TR)**

(72) Inventors:
• **EGEMEN, Tufan
  45030 Manisa (TR)**
• **DERELI, Ulas
  45030 Manisa (TR)**

(74) Representative: **Flint, Adam
  Page White & Farrer
  Bedford House
  John Street
  London WC1N 2BF (GB)**

(54) **PRINTED CIRCUIT BOARD AND METHOD OF MANUFACTURE**

(57) A printed circuit board (200) comprises at least one electronic component (201, 202, 203) and a plurality of resistors (210). The plurality of resistors (210) are arranged to encode an indication of the at least one electronic component (201, 202, 203).

Figure 2

**Description**

Technical Field

The present disclosure relates to a printed circuit board and a method of manufacturing a printed circuit board.

Background

In mass production of printed circuit boards (PCBs), such as mainboards of electronic display devices, motherboards of computing devices, etc., a barcode label is attached or etched onto the PCB to indicate PCB assembly information and PCB options. The barcode label indicates the PCB assembly options, including for example details of the specific components present on the PCB. This information can be helpful in case of troubleshooting, PCB failure, etc. However, access to the barcode may be difficult or restricted.

Summary

According to a first aspect disclosed herein, there is provided a printed circuit board comprising: at least one electronic component; and a plurality of resistors; wherein the plurality of resistors are arranged to encode an indication of the at least one electronic component.

The indication may be an indication of the printed circuit board as a whole, that is, an indication of the specification of the hardware and/or software of the printed circuit board, including for example the specific components present in that particular printed circuit board. The indication may correspond for example to a unique serial number allocated to that particular printed circuit board by the manufacturer, and which the manufacturer uses to store details of the specification in a database or the like.

In an example, the plurality of resistors is arranged in that at least one of the resistors has been destroyed to encode the indication of the at least one electronic component.

In an example, the at least one resistor is destroyed by being burnt.

In an example, the printed circuit board comprises a processor connected to the plurality of resistors, and the processor is configured to determine the indication of the at least one electronic component from voltages measured at the plurality of resistors.

In an example, the plurality of resistors are arranged on a plurality of lines, each line having at least one resistor, and the indication of the at least one electronic component is encoded in voltages measurable on the lines.

In an example, the indication corresponds to a serial number comprising a set of characters and each character is encoded on a respective one of the lines.

In an example, each line of resistors is arranged in a potential divider circuit.

In an example, the printed circuit board is a mainboard of an electronic display device.

In an example, the printed circuit board is a motherboard of an electronic computing device.

According to a second aspect disclosed herein, there is provided a method of manufacturing a printed circuit board comprising at least one electronic component; the method comprising: providing a plurality of resistors on the printed circuit board so as to encode an indication of the at least one electronic component by voltages which are measurable at the plurality of resistors.

In an example, the indication is encoded in the resistors by destroying at least one of the plurality of resistors.

In an example, the step of destroying the at least one resistor is performed by burning the resistor.

In an example, the plurality of resistors are arranged on a plurality of lines, each line having at least one resistor, and the indication corresponds to a serial number comprising a set of characters and each character is encoded on a respective one of the lines.

In an example, the printed circuit board is a mainboard of an electronic display device.

In an example, the printed circuit board is a motherboard of an electronic computing device.

Brief Description of the Drawings

To assist understanding of the present disclosure and to show how embodiments may be put into effect, reference is made by way of example to the accompanying drawings in which:

Figure 1 shows schematically an example of a known printed circuit board;

Figure 2 shows schematically an example of a printed circuit board in accordance with an embodiment of the present invention;

Figure 3 shows an example resistor array; and

Figure 4 shows another example resistor array.

Detailed Description

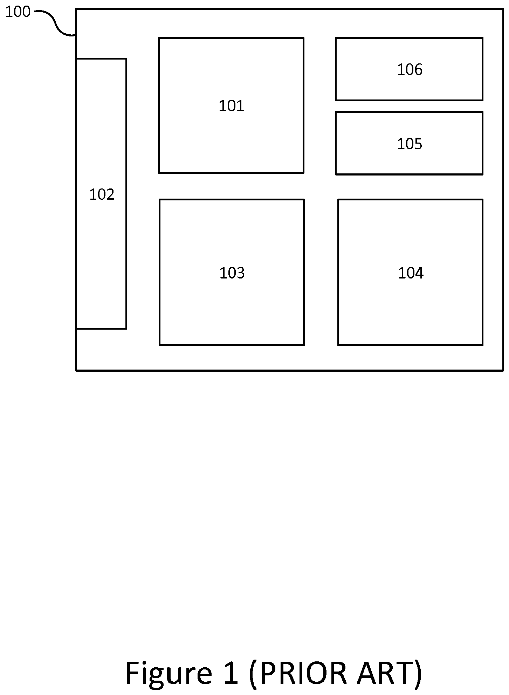

Figure 1 shows a schematic block diagram of a known PCB 100. The PCB 100 comprises a main processor 101, an interface 102, one or more secondary processors 103, 104, one or more memory slots 105, various other components (not shown) and a barcode 106. The PCB 100 is an example of a PCB commonly found in a variety of electronic devices such as televisions, DVD players, set-top boxes, desktop and laptop computers, printers, electric appliances such as white goods, etc. For example, most televisions and other display devices comprise a PCB, often referred to as a "mainboard", for controlling the display and other functions. Depending on the device in which the PCB 100 is disposed, it may perform different or additional functionality. Hence, it is understood that PCB 100 may comprise different components depending on its use.

In the example of Figure 1, the PCB 100 is a mainboard of a display device and hence the secondary processors 103, 104 in Figure 1 may be an audio processor 103 and a video processor 104. For clarity, the PCB 100 may therefore be referred to as mainboard 100 in this example.

The audio processor 103 and video processor 104 are responsible for audio- and video-related processing tasks, respectively, as known in the art. In operation, the main processor 101 performs general processing tasks and delegates specific audio- and video-related tasks to the audio processor 103 and video processor 104 as appropriate.

The interface 102 is a port for input and output of data signals to and from the mainboard 100. The main processor 100 is arranged to receive data from external sources and to transmit data to (potentially different) external sources via the interface 102.

The memory slots 105 comprise at least one electronic memory device such as a RAM or ROM. The main processor 101 is configured to, in use, store data in and/or retrieve data from the memory 105. Each of the audio processor 103 and video processor 104 may be provided with their own separate memory (not shown in Figure 1).

The particular specifications of the mainboard are set at the manufacturing stage when the components 101-105 are installed on the PCB 100. The specifications may include, for example, a processing power of the main processor 101, a size of the memory 105, etc. Hence there are various options regarding the particular hardware components installed on the PCB 100. There are also various options regarding the particular software and/or firmware with which the hardware components 101-105 are configured.

In a mainboard production line, the assembly process options are accomplished according to the product final specifications. Over time, different components may be used in the manufacture of the mainboard, even though the mainboard may be for the same model of electronic device such as a television, DVD player, set-top box, computer, etc. Therefore each mainboard may have different hardware and software option combinations. These options are defined in a main system of the manufacturer which may change from one production run to the next. A record of the different hardware and software option combinations used for a specific mainboard is maintained by the manufacturer. To aid in this and as a reference for the manufacturer, a unique serial number is assigned to each mainboard which corresponds to the record of the hardware/software options of the board and related specifications that is kept by the manufacturer.

The mainboard 100 is provided with a barcode 106 as shown in Figure 1. The barcode 106 is typically provided on a label, which is stuck to the mainboard 100, or is etched into the mainboard 100, as part of the production process by the manufacturer. This barcode 106 corresponds to the unique serial number assigned to the mainboard and therefore in effect provides an indication of the hardware and/or software specifications of the mainboard 100, including the specific components used on that particular mainboard 100. Hence, the specification of the mainboard 100 may be obtained by scanning the barcode 106 and looking up the specification of the mainboard 100 from a database maintained by the manufacturer, which records the specification against the barcode 106 for that mainboard 100.

In some situations, such as if the mainboard 100 malfunctions, an end user of the display device may require the data encoded in the barcode 106, for example so as to be able to replace components themselves or to provide information about the mainboard 100 to the manufacturer or some other repairer. In order to get the mainboard data from the barcode 106, the display device must be opened to allow access to the mainboard 100. However, doing so may void a warranty of the display device if performed by the end user. This means that the end user must typically take the whole apparatus (e.g. a television, DVD player, set-top box, or computer or the like) to the manufacturer or an authorized service agent or the like to perform this action, which is a time-consuming, inconvenient and potentially expensive process.

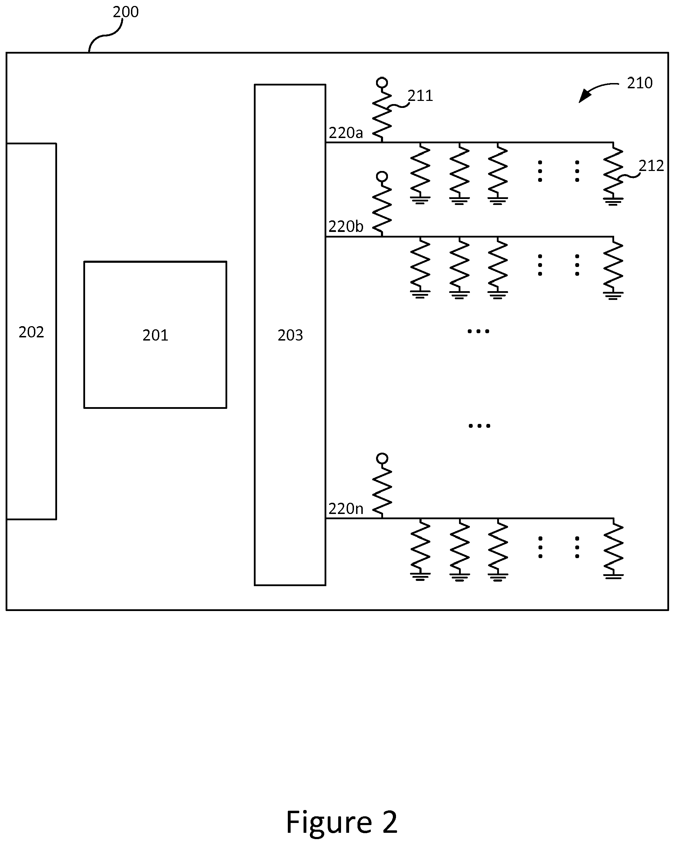

Figure 2 shows a schematic diagram of an example of a mainboard 200 in accordance with an embodiment of the present invention.

The mainboard 200 is a PCB comprising a main processor 201, an interface 202 and other electronic components such as a video processor, audio processor, etc., etc. (not shown in Figure 2).

The mainboard 200 is also provided with a plurality of resistors 210 and an analogue to digital converter (ADC) 203. The resistors 210 are arranged to encode an indication of the specification of the mainboard 200. This indication can be read by the main processor 201 and therefore output via the interface 202 to an external reader or for display on the display device in the case that the mainboard 200 is incorporated in a display device. Alternatively or additionally, a separate interface may be provided to allow the indication to be read by some other device. This may be for example a UART (universal asynchronous receiver/transmitter) connection. Either way, a user is therefore able to access specification information via data received from the mainboard interface 202 or some other interface and the user does not have to physically access the mainboard 200. The indication can therefore be obtained without having to open up the device, such as a television or computer, etc. The indication can even be obtained remotely by connecting some device to read the indication provided by the resistors 210 (again via a UART connection for example) and allowing access to that device by say a manufacturer or service agent over the Internet.

Various different arrangements of the resistors 210 are possible in order to encode the specification information. In the example of Figure 2, the resistors 210 are arranged in a plurality of sets of resistors, arranged in lines 220a, 220b-220n. Each line is connected to a single input of the ADC 203. Each line of resistors 220a, 220b-220n comprises an input resistor 211 and at least one line resistor 212. The input resistor 211 is connected between an input voltage $V_{in}$ and the line. The line resistors 212 are connected between the line and ground. Each line therefore acts as a potential divider circuit. The voltage between the line 220 and ground (the output voltage of that line) depends on the number of line resistors 212. When the resistance values of the input resistor 211 and all line resistors 212 are not equal, the output voltage also depends on the particular values of the resistance of the resistors 211, 212.

The ADC 203 has a plurality of input pins, each connected to a respective line of resistors 220. The ADC 203 is configured to convert the (analogue) voltage on each line 220 into a digital value suitable for use by the main processor 201. Thereby, the main processor 201 is able to determine the voltage level on each of the lines 220.

To encode the specification data, in an example the serial number that has been allocated to the specific mainboard 200 by the manufacturer is first transformed into ASCII (American Standard Code for Information Interchange) format. Then, the serial number is split into subgroups (e.g. where a subgroup corresponds to a single ASCII character or a set of ASCII characters from the serial number). Each subgroup is assigned to a voltage level (e.g. the character "A" = 5V, the character "B" = 4.8V, etc.). The required number of line resistors 212 on a line 220 are then destroyed (e.g. by burning, using for example a laser trimmer on the production line) to encode that subgroup on that line 220. The main processor 201 can therefore read the serial number by determining the voltages on the lines 220 and converting this back to ASCII format.

Note that it is also possible that the resistors 210 are simply arranged such that the corresponding voltages are present on each line 220 in the first place during manufacture, without destroying resistors (e.g. burning by a laser trimmer). That is, instead of manufacturing the mainboard 200 with e.g. ten line resistors 212 per line and then destroying m of them (leaving 10-m line resistors 212), each line 220 could be manufactured to have only 10-m line resistors 212 to begin with.

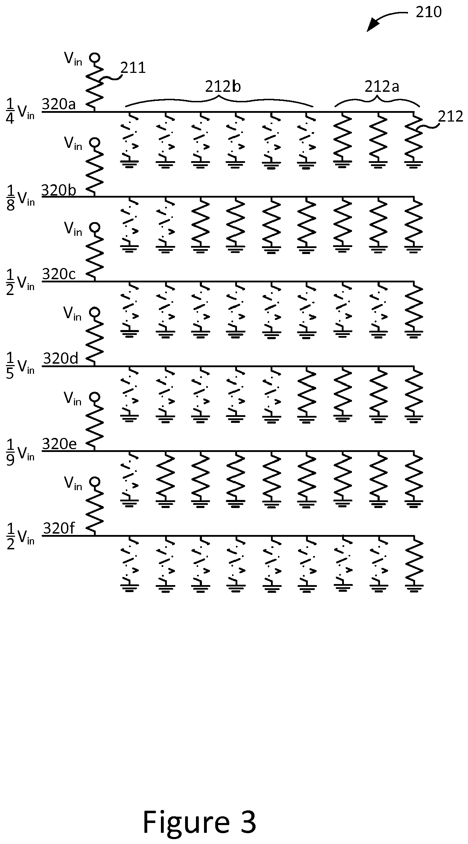

Figure 3 shows an example arrangement of resistors 210 arranged on six lines 320a-f each comprising an input resistor 211 and nine line resistors 212. In this example, the input resistor 211 and all of the line resistors 212 have the same resistance value. This means that the output voltage of a line $V_{out}$ is dependent only on the number of remaining (not burnt) line resistors 212 via the formula:

$$V_{out} = \left(\frac{1}{n+1}\right) * V_{in}$$

where n is the number of line resistors 212 remaining on that line.

The output voltage on each line 320a-f is indicated in Figure 3 as a fraction of the input voltage $V_{in}$. For example, line 320a comprises three (un-burnt) resistors 212a and six burnt resistors 212b, and the output voltage of line 320a is therefore $0.75V_{in}$.

Note that the output voltage $V_{out}$ of a line 320 depends only on the number of un-burnt resistors 212a, not which specific ones of the resistors 212 are burnt. This is because in this example all of the resistors 210 have the same resistance value.

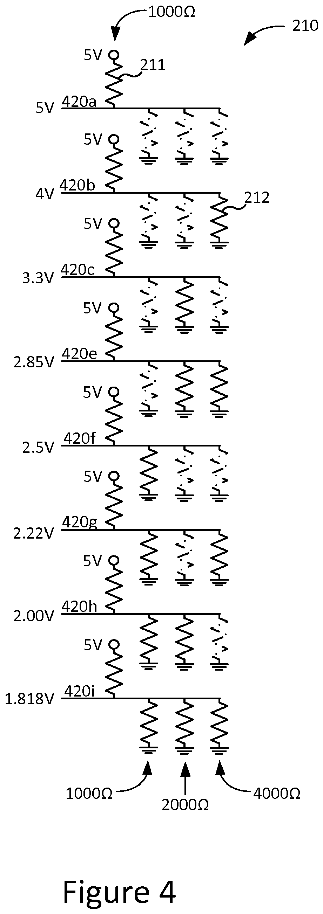

Figure 4 shows another example arrangement of resistors 210 which do not all have the same resistance value. This has the advantage that the specific ones of the line resistors 212 which are burnt and which remain unburnt matters, and therefore this arrangement can in general be used to encode more information for the same number of resistors 210.

The resistors 210 are, in this example, arranged in eight lines 420a-i, each line 420 comprising an input resistor 211 and three line resistors 212. The input resistor 211 on each line 420 has a resistance value of 1000Ω, and the three line resistors 212 have resistance values of 1000Ω, 2000Ω, and 4000Ω.

The input voltage for each line 420 is 5V. The output voltage of each line 420 is shown in Figure 4 and also in the table below (where "X" indicates a burnt resistor and "✓" indicates a present, unburnt, resistor).

| Input Voltage (V) | Resistors (Ω) | | | Output Voltage (V) |
|---|---|---|---|---|
| | 1000 | 2000 | 4000 | |
| 5.00 | X | X | X | 5 |
| 5.00 | X | X | ✓ | 4 |
| 5.00 | X | ✓ | X | 3.3 |
| 5.00 | X | ✓ | ✓ | 2.85 |
| 5.00 | ✓ | X | X | 2.5 |
| 5.00 | ✓ | X | ✓ | 2.22 |
| 5.00 | ✓ | ✓ | X | 2.00 |
| 5.00 | ✓ | ✓ | ✓ | 1.818 |

Hence, three line resistors 212 per line is sufficient to encode eight possibilities for a subgroup. In this example, it may be preferable to convert the serial number to be encoded into an octal numeral system, as this allows each digit to be encoded on a single line 420. For example, if the first digit of the serial number (base-8) is "4", the laser trimmer will burn the necessary line resistors 212 on the first line 420a such that the output voltage of line 420a is a voltage level assigned to the digit "4".

It will be understood that the processor or processing system or circuitry referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors and a digital signal processor or processors, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

**Claims**

1.  A printed circuit board comprising:

    at least one electronic component; and
    a plurality of resistors;
    wherein the plurality of resistors are arranged to encode an indication of the at least one electronic component.

2.  A printed circuit board according to claim 1, wherein the plurality of resistors is arranged in that at least one of the resistors has been destroyed to encode the indication of the at least one electronic component.

3.  A printed circuit board according to claim 2, wherein the at least one resistor is destroyed by being burnt.

4.  A printed circuit board according to any of claims 1 to 3, comprising:

a processor connected to the plurality of resistors;
wherein the processor is configured to determine the indication of the at least one electronic component from voltages measured at the plurality of resistors.

5.  A printed circuit board according to any of claims 1 to 4, wherein the plurality of resistors are arranged on a plurality of lines, each line having at least one resistor, the indication of the at least one electronic component being encoded in voltages measurable on the lines.

6.  A printed circuit board according to claim 5, wherein the indication corresponds to a serial number comprising a set of characters and each character is encoded on a respective one of the lines.

7.  A printed circuit board according to claim 5 or claim 6, wherein each line of resistors is arranged in a potential divider circuit.

8.  A printed circuit board according to any of claims 1 to 7, wherein the printed circuit board is a mainboard of an electronic display device.

9.  A printed circuit board according to any of claims 1 to 7, wherein the printed circuit board is a motherboard of an electronic computing device.

10. A method of manufacturing a printed circuit board comprising at least one electronic component; the method comprising:

    providing a plurality of resistors on the printed circuit board so as to encode an indication of the at least one electronic component by voltages which are measurable at the plurality of resistors.

11. A method according to claim 10, wherein the indication is encoded in the resistors by destroying at least one of the plurality of resistors.

12. A method according to claim 11, wherein the step of destroying the at least one resistor is performed by burning the resistor.

13. A method according to any of claims 10 to 12, wherein the plurality of resistors are arranged on a plurality of lines, each line having at least one resistor, and the indication corresponds to a serial number comprising a set of characters and each character is encoded on a respective one of the lines.

14. A method according to any of claims 10 to 13, wherein the printed circuit board is a mainboard of an electronic display device.

15. A method according to any of claims 10 to 14, wherein the printed circuit board is a motherboard of an electronic computing device.

100

101

106

105

102

103

104

Figure 1 (PRIOR ART)

Figure 2

210

$V_{in}$  211

$\frac{1}{4}V_{in}$  320a  212b  212a  212

$V_{in}$

$\frac{1}{8}V_{in}$  320b

$V_{in}$

$\frac{1}{2}V_{in}$  320c

$V_{in}$

$\frac{1}{5}V_{in}$  320d

$V_{in}$

$\frac{1}{9}V_{in}$  320e

$V_{in}$

$\frac{1}{2}V_{in}$  320f

# Figure 3

Figure 4

Europäisches
Patentamt

European
Patent Office

Office européen
des brevets

## EUROPEAN SEARCH REPORT

**Application Number**

EP 17 18 7355

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/156146 A1 (NAKANO SATOSHI [JP] ET AL) 12 August 2004 (2004-08-12) * paragraphs [0003], [0027] - [0029], [0032], [0036], [0040], [0042], [0043]; figures 3-5 * | 1-15 | INV. H05K1/02 |
| X | US 2015/287703 A1 (FAISTAUER CHRISTIAN [AT] ET AL) 8 October 2015 (2015-10-08) * paragraphs [0010], [0017], [0031], [0034], [0035], [0037], [0040]; figures * | 1-3,5-15 | |
| X | "HARDWARE ENGINEERING CHANGE LEVEL IDENTIFICATION REGISTER", IBM TECHNICAL DISCLOSURE BULLETIN, INTERNATIONAL BUSINESS MACHINES CORP. (THORNWOOD), US, vol. 33, no. 1A, 1 June 1990 (1990-06-01), page 320/321, XP000117748, ISSN: 0018-8689 * the whole document * | 1,4-10, 13-15 | |
| X | US 4 437 229 A (BITLER JOEL R [US] ET AL) 20 March 1984 (1984-03-20) * column 4, line 47 - column 5, line 50; claims * | 1-3,6, 8-15 | TECHNICAL FIELDS SEARCHED (IPC) H05K H01L G06F |

The present search report has been drawn up for all claims

| Place of search | Date of completion of the search | Examiner |
|---|---|---|
| Munich | 2 February 2018 | Batev, Petio |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................
& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 17 18 7355

This annex lists the patent family members relating to the patent documents cited in the above-mentioned European search report.
The members are as contained in the European Patent Office EDP file on
The European Patent Office is in no way liable for these particulars which are merely given for the purpose of information.

02-02-2018

| Patent document cited in search report | | Publication date | Patent family member(s) | | Publication date |
|---|---|---|---|---|---|
| US 2004156146 | A1 | 12-08-2004 | CN | 1570657 A | 26-01-2005 |
| | | | JP | 2004241033 A | 26-08-2004 |
| | | | SG | 112901 A1 | 28-07-2005 |
| | | | US | 2004156146 A1 | 12-08-2004 |
| US 2015287703 | A1 | 08-10-2015 | DE | 102012110397 A1 | 30-04-2014 |
| | | | EP | 2915192 A1 | 09-09-2015 |
| | | | JP | 2015534281 A | 26-11-2015 |
| | | | US | 2015287703 A1 | 08-10-2015 |
| | | | WO | 2014067717 A1 | 08-05-2014 |
| US 4437229 | A | 20-03-1984 | NONE | | |

EPO FORM P0459

For more details about this annex : see Official Journal of the European Patent Office, No. 12/82